(19) **Europäisches Patentamt European Patent Office Office européen des brevets**

(11) **EP 4 660 650 A1**

(12) **EUROPEAN PATENT APPLICATION**
published in accordance with Art. 153(4) EPC

(43) Date of publication:
**10.12.2025 Bulletin 2025/50**

(21) Application number: **24803567.7**

(22) Date of filing: **02.02.2024**

(51) International Patent Classification (IPC):
**G01R 31/392** (2019.01)    **G01R 31/396** (2019.01)
**G01R 31/385** (2019.01)    **G01R 19/00** (2006.01)
**G01R 19/30** (2006.01)    **G01R 19/165** (2006.01)
**G01R 31/367** (2019.01)    **B60L 58/10** (2019.01)

(52) Cooperative Patent Classification (CPC):
Y02E 60/10

(86) International application number:
**PCT/KR2024/001613**

(87) International publication number:
**WO 2024/232510 (14.11.2024 Gazette 2024/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.05.2023 KR 20230059022**

(71) Applicant: **LG Energy Solution, Ltd. Seoul 07335 (KR)**

(72) Inventors:
• **KIM, Ji Su Daejeon 34122 (KR)**
• **SUNG, Yong Chul Daejeon 34122 (KR)**

(74) Representative: **Plasseraud IP 104 Rue de Richelieu CS92104 75080 Paris Cedex 02 (FR)**

(54) **BATTERY MANAGEMENT APPARATUS AND OPERATING METHOD THEREOF**

(57)    An operating method of a battery management apparatus according to an embodiment disclosed herein includes measuring a voltage of each of a plurality of battery cells, calculating a first deviation, which is a deviation between a long moving average and a short moving average of a battery cell voltage of each of the plurality of battery cells, calculating a second deviation, which is a deviation between a long moving average and a short moving average of an average voltage of the plurality of battery cells, and calculating a first diagnosis deviation between the first deviation and the second deviation for each of the plurality of battery cells, setting a diagnosis battery cell by diagnosing at least one of the plurality of battery cells based on the first diagnosis deviation of each of the plurality of battery cells, and determining whether the diagnosis battery cell is diagnosed normally, by comparing a first diagnosis deviation of a battery cell having a maximum value among first diagnosis deviations of battery cells different from the diagnosis battery cell with the first diagnosis deviation of the diagnosis battery cell.

<u>200</u>

| VOLTAGE MEASUREMENT UNIT <u>210</u> | CONTROLLER <u>220</u> |

FIG.2

**Description**

**[Technical Field]**

CROSS-REFERENCE TO RELATED APPLICATION

This application claims priority to and the benefit of Korean Patent Application No. 10-2023-0059022 filed in the Korean Intellectual Property Office on May 8, 2023, the entire content of which is incorporated herein by reference.

TECHNICAL FIELD

Embodiments disclosed herein relate to a battery management apparatus and an operating method thereof.

**[Background Art]**

An electric vehicle is supplied with electricity from outside to charge a battery cell, and then a motor is driven by a voltage charged in the battery cell to obtain power. A battery cell undergoes internal deformation and degeneration through various charging and discharging during production and use, with physical/chemical characteristics thereof changing, resulting in venting due to internal short-circuit, external short-circuit, and lithium precipitation or in an under-voltage defect in which a voltage of a battery cell decreases below a certain level.

When a defect occurs inside the battery cell, direct problems may occur in the battery cell, such as deterioration of battery cell performance, the increased possibility of ignition due to leakage of an electrolyte, etc. Thus, a technique for determining whether the battery cell is abnormal is required.

A conventional battery management apparatus may diagnose voltage abnormality of a battery cell by using a voltage deviation of an individual battery cell with respect to an average voltage of battery cells, but this method may not adjust a threshold that is a criterion for diagnosing an abnormal battery cell below a certain level due to its vulnerability to noise, and may not detect an abnormal voltage of a battery cell due to micro-disconnection occurring in an electric vehicle.

**[Disclosure]**

**[Technical Problem]**

Embodiments disclosed herein aim to provide a battery management apparatus and an operating method thereof in which noise of a deviation between a long moving average and a short moving average of a voltage of a battery cell may be removed to accurately diagnose an abnormal battery cell.

Embodiments disclosed herein also aim to provide a battery management apparatus and an operating method thereof in which it is possible to prevent over-checking due to a voltage inflection point (an inflection point of an open circuit voltage) in a process of detecting an abnormal behavior of a voltage.

Technical problems of the embodiments disclosed herein are not limited to the above-described technical problems, and other unmentioned technical problems would be clearly understood by one of ordinary skill in the art from the following description.

**[Technical Solution]**

An operating method of a battery management apparatus according to an embodiment disclosed herein includes measuring a voltage of each of a plurality of battery cells, calculating a first deviation, which is a deviation between a long moving average and a short moving average of a battery cell voltage of each of the plurality of battery cells, calculating a second deviation, which is a deviation between a long moving average and a short moving average of an average voltage of the plurality of battery cells, and calculating a first diagnosis deviation between the first deviation and the second deviation for each of the plurality of battery cells, setting a diagnosis battery cell by diagnosing at least one of the plurality of battery cells based on the first diagnosis deviation of each of the plurality of battery cells, and determining whether the diagnosis battery cell is diagnosed normally, by comparing a first diagnosis deviation of a battery cell having a maximum value among first diagnosis deviations of battery cells different from the diagnosis battery cell with the first diagnosis deviation of the diagnosis battery cell.

In an embodiment, the controller may be further configured to determine that the diagnosis battery cell is diagnosed normally, when a product of the first diagnosis deviation of the diagnosis battery cell and a set value exceeds the first diagnosis deviation of the battery cell having the maximum value and determine that the diagnosis battery cell is misdiagnosed, when the product of the first diagnosis deviation of the diagnosis battery cell and the set value is less than or equal to the first diagnosis deviation of the battery cell having the maximum value.

In an embodiment, the controller may be further configured to calculate the first diagnosis deviation of each of the plurality of battery cells for each reference time and update the first diagnosis deviation of the battery cell having the maximum value among the first diagnosis deviations of the battery cells different from the diagnosis battery cell, for each reference time.

In an embodiment, the controller may be further configured to calculate the first diagnosis deviation of each of the plurality of battery cells for each reference time and update a maximum value of the first diagnosis deviation of the diagnosis battery cell for each reference time.

In an embodiment, the controller may be further configured to determine that the diagnosis battery cell is diagnosed normally, when a minimum value among the voltages of the plurality of battery cells is greater than a voltage at the time of diagnosis of the diagnosis battery cell and diagnosis of the diagnosis battery cell is not determined as misdiagnosis.

In an embodiment, the controller may be further configured to update the maximum value among the first diagnosis deviations of the battery cells different from the diagnosis battery cell for each reference time and determine whether the diagnosis battery cell is diagnosed normally by comparing the updated maximum value with the first diagnosis deviation of the diagnosis battery cell.

In an embodiment, the controller may be further configured to calculate a second diagnosis deviation of each of the plurality of battery cells based on a reference value obtained by multiplying the second deviation among the first diagnosis deviations of the plurality of respective battery cells by a threshold constant and set the diagnosis battery cell by diagnosing at least one of the plurality of battery cells based on the second diagnosis deviation of each of the plurality of battery cells.

In an embodiment, the controller may be further configured to set, as the reference value, a maximum value between a value, obtained by multiplying the second deviation by a first threshold constant, and a second threshold constant, calculate a second diagnosis deviation of each of the plurality of battery cells by excluding a first diagnosis deviation less than or equal to the reference value among the first diagnosis deviations of the plurality of respective battery cells, perform normalization by dividing the second diagnosis deviation of each of the plurality of battery cells by a maximum value between a value, obtained by multiplying the second deviation by a third threshold constant, and a fourth threshold constant to calculate a third diagnosis deviation of each of the plurality of battery cells, calculate a skewness of each of the plurality of battery cells by dividing a value, obtained by adding a minimum value among the third diagnosis deviations of the plurality of respective battery cells, to the third diagnosis deviation of each of the plurality of battery cells, calculate a fourth diagnosis deviation of each of the plurality of battery cells by multiplying the skewness to the third diagnosis deviation of each of the plurality of battery cells, and set the diagnosis battery cell by diagnosing at least one of the plurality of battery cells based on whether the fourth diagnosis deviation of each of the plurality of battery cells exceeds a threshold.

An operating method of a battery management apparatus according to an embodiment disclosed herein includes measuring a voltage of each of a plurality of battery cells, calculating a first deviation, which is a deviation between a long moving average and a short moving average of a battery cell voltage of each of the plurality of battery cells, calculating a second deviation, which is a deviation between a long moving average and a short moving average of an average voltage of the plurality of battery cells, and calculating a first diagnosis deviation between the first deviation and the second deviation for each of the plurality of battery cells, setting a diagnosis battery cell by diagnosing at least one of the plurality of battery cells based on the first diagnosis deviation of each of the plurality of battery cells, and determining whether the diagnosis battery cell is diagnosed normally, by comparing a first diagnosis deviation of a battery cell having a maximum value among first diagnosis deviations of battery cells different from the diagnosis battery cell with the first diagnosis deviation of the diagnosis battery cell.

In an embodiment, the determining of whether the diagnosis battery cell is diagnosed normally, by comparing the first diagnosis deviation of the battery cell having the maximum value among first diagnosis deviations of battery cells different from the diagnosis battery cell with the first diagnosis deviation of the diagnosis battery cell may include determining that the diagnosis battery cell is diagnosed normally, when a product of the first diagnosis deviation of the diagnosis battery cell and a set value exceeds the first diagnosis deviation of the battery cell having the maximum value and determining that the diagnosis battery cell is misdiagnosed, when the product of the first diagnosis deviation of the diagnosis battery cell and the set value is less than or equal to the first diagnosis deviation of the battery cell having the maximum value.

In an embodiment, the operating method may further include calculating the first diagnosis deviation of each of the plurality of battery cells for each reference time and updating the first diagnosis deviation of the battery cell having the maximum value among the first diagnosis deviations of the battery cells different from the diagnosis battery cell, for each reference time.

In an embodiment, the operating method may further include calculating the first diagnosis deviation of each of the plurality of battery cells for each reference time and updating a maximum value of the first diagnosis deviation of the diagnosis battery cell for each reference time.

In an embodiment, the determining of whether the diagnosis battery cell is diagnosed normally, by comparing the first diagnosis deviation of the battery cell having the maximum value among first diagnosis deviations of battery cells different from the diagnosis battery cell with the first diagnosis deviation of the diagnosis battery cell may include updating the maximum value among the first diagnosis deviations of the battery cells different from the diagnosis battery cell for each reference time and determining whether the diagnosis battery cell is diagnosed normally by comparing the updated maximum value with the first diagnosis deviation of the diagnosis battery cell.

In an embodiment, the setting of the diagnosis battery cell by diagnosing at least one of the plurality of battery cells based on the first diagnosis deviation of each of the plurality of battery cells may include calculating a second diagnosis deviation of each of the plurality of battery cells based on a reference value obtained by multiplying the second deviation among the first diagnosis deviations of the plurality of respective battery cells by a threshold constant and setting the diagnosis battery cell by diagnosing at least one of the plurality of battery cells based on the second diagnosis deviation of each of the plurality of battery cells.

In an embodiment, the setting of the diagnosis battery cell by diagnosing at least one of the plurality of battery cells based on the second diagnosis deviation of each of the plurality of battery cells may include setting, as the reference value, a maximum value between a value, obtained by multiplying the second deviation by a first threshold constant, and a second threshold constant, calculating a second diagnosis deviation of each of the plurality of battery cells by excluding a first diagnosis deviation less than or equal to the reference value among the first diagnosis deviations of the plurality of respective battery cells, performing normalization by dividing the second diagnosis deviation of each of the plurality of battery cells by a maximum value between a value, obtained by multiplying the second deviation by a third threshold constant, and a fourth threshold constant to calculate a third diagnosis deviation of each of the plurality of battery cells, calculating a skewness of each of the plurality of battery cells by dividing a value, obtained by adding a minimum value among the third diagnosis deviations of the plurality of respective battery cells, to the third diagnosis deviation of each of the plurality of battery cells, calculating a fourth diagnosis deviation of each of the plurality of battery cells by multiplying the skewness to the third diagnosis deviation of each of the plurality of battery cells, and setting the diagnosis battery cell by diagnosing at least one of the plurality of battery cells based on whether the fourth diagnosis deviation of each of the plurality of battery cells exceeds a threshold.

**[Advantageous Effects]**

The battery management apparatus and the operating method thereof according to an embodiment disclosed herein may accurately diagnose an abnormal battery cell by removing noise of a deviation between a long moving average and a short moving average of a voltage of a battery cell.

Moreover, the battery management apparatus and the operating method according to an embodiment disclosed herein may prevent over-checking based on a voltage inflection point of a plurality of battery cells, detect a minute signal by lowering a threshold, and filter noise, thereby improving a detection rate and reducing an over-checking rate.

Furthermore, the battery management apparatus and the operating method according to an embodiment disclosed herein may distinguish a voltage inflection point commonly appearing according to characteristics of a cell, and a voltage inflection point caused by a defect, thereby preventing over-checking and improving a diagnosis rate.

Moreover, various effects recognized directly or indirectly from the disclosure may be provided.

**[Description of Drawings]**

FIG. 1 illustrates a battery cell pack according to an embodiment disclosed herein.

FIG. 2 is a block diagram illustrating a configuration of a battery management apparatus, according to an embodiment disclosed herein.

FIG. 3 is a graph showing a voltage of a battery cell according to an embodiment disclosed herein.

FIG. 4 is a flowchart illustrating a method of diagnosing a battery cell of a controller, according to an embodiment disclosed herein.

FIG. 5A is a graph showing a first diagnosis deviation of a battery cell according to an embodiment disclosed herein.

FIG. 5B is a graph showing a third diagnosis deviation of a battery cell according to an embodiment disclosed herein.

FIG. 5C is a graph showing a skewness of a third diagnosis deviation of a battery cell according to an embodiment disclosed herein.

FIG. 5D is a graph showing a fourth diagnosis deviation of a battery cell according to an embodiment disclosed herein.

FIG. 6 is a flowchart of a battery management apparatus according to another embodiment disclosed herein.

FIG. 7 is a diagram for describing a difference in voltage inflection point between a plurality of battery cells according to another embodiment disclosed herein.

FIGS. 8A and 8B are views for describing a difference in first diagnosis deviation based on a difference in voltage inflection point between battery cells, according to another embodiment disclosed herein.

FIGS. 9 and 10 are views for describing a misdiagnosis detection method of a battery management apparatus, according to another embodiment disclosed herein.

FIG. 11 is a view for describing an operating method of a battery management apparatus, according to another embodiment disclosed herein.

FIG. 12 is a view for describing in detail an operating method of a battery management apparatus, according to another embodiment disclosed herein.

FIG. 13 is a block diagram showing a hardware configuration of a computing system for performing an operating method of a battery management apparatus, according to an embodiment disclosed herein.

**[Mode for Invention]**

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

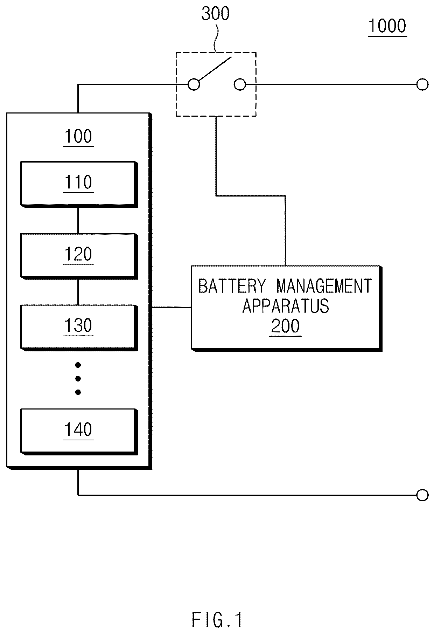

FIG. 1 illustrates a battery cell pack according to an embodiment disclosed herein.

Referring to FIG. 1, a battery cell pack 1000 according to an embodiment disclosed herein may include a battery cell module 100, a battery management apparatus 200, and a relay 300. According to various embodiments, the battery cell module 100 may be a battery cell, and in this case, the battery cell pack 1000 may have a cell-to-pack structure.

Meanwhile, although one battery cell module 100 is illustrated in FIG. 1, the battery cell module 100 may be configured in plural and the battery cell pack 1000 may have a stacked structure of a plurality of battery cell modules, according to an embodiment. The battery cell module 100 may include a plurality of battery cells 110, 120, 130, and 140. Although the plurality of battery cells are illustrated as four in FIG. 1, the present disclosure is not limited thereto, and the battery cell module 100 may include n battery cells (n is a natural number equal to or greater than 2).

The battery cell module 100 may supply power to a target device (not shown). To this end, the battery cell module 100 may be electrically connected to the target device. Herein, the target device may include an electrical, electronic, or mechanical device that operates by receiving power from the battery cell pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery cell available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery cell module 100 is illustrated in FIG. 1, the battery cell module 100 may be configured in plural according to an embodiment.

The battery management apparatus (or a battery management system (BMS)) 200 may manage and/or control a state and/or an operation of the battery cell module 100. For example, the battery management apparatus 200 may manage and/or control the states and/or operations of the plurality of battery cells 110, 120, 130, and 140 included in the battery cell module 100. The battery management apparatus 200 may manage charging and/or discharging of the battery cell module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery cell pack 1000.

In addition, the battery management apparatus 200 may monitor a voltage, a current, a temperature, etc., of the battery cell module 100 and/or each of the plurality of battery cells 110, 120, 130, and 140 included in the battery cell module 100. A sensor or various measurement modules for monitoring performed by the battery management apparatus 200, which are not shown, may be additionally installed in the battery cell module 100, a charging/discharging path, any position of the battery cell module 100, etc. The battery management apparatus 200 may calculate a parameter indicating a state of the battery cell module 100, e.g., a state of charge (SoC), a state of health (SoH) etc., based on a measurement value such as monitored voltage, current, temperature, etc.

For the plurality of battery cells 110, 120, 130, and 140, as a period of use or the number of times of use increases, a capacity may decrease, internal resistance may increase, and various factors of the battery may change. The battery management apparatus 200 may diagnose an abnormal phenomenon inside the plurality of battery cells 110, 120, 130, and 140 based on data of various factors changing with deterioration of the battery cells.

When a defect occurs in a battery cell due to various causes such as a detect in a production stage, internal deformation and degeneration through a plurality of charging and discharging, an external impact, etc., a voltage change may occur more quickly and significantly in comparison to a normal battery cell. By using a phenomenon in which a voltage change is faster and more significant in a battery cell having an internal defect occurring than in a normal battery cell in an idle period, the battery management apparatus 200 may compare voltage data of the idle period of each of the plurality of battery cells 110, 120, 130, and 140 with statistic normal voltage data of an idle period of a normal battery cell to diagnose an abnormal battery cell among the plurality of battery cells 110, 120, 130, and 140.

Specifically, in the abnormal battery cell, a voltage drops in an idle period after charging when compared to a normal battery cell, and a greater deviation in voltage behavior occurs than a voltage behavior of the normal battery cell, such that the voltage behavior is biased to one side, resulting in a great skewness. The battery management apparatus 200 may determine whether there is an abnormal battery cell among the plurality of battery cells 110, 120, 130, and 140 by using a greater deviation and a greater skewness of the voltage behavior of the abnormal battery cell than those of the voltage behavior of the normal battery cell.

According to an embodiment, the battery management apparatus 200 may determine whether there is an abnormal battery cell, based on a voltage deviation of the plurality of battery cells 110, 120, 130, and 140 during charging. In this case, the battery management apparatus 200 may determine whether there is an abnormal battery cell by collectively considering the voltage deviation of the plurality of battery cells 110, 120, 130, and 140 and whether the plurality of battery cells 110, 120, 130, and 140 pass a voltage inflection point, and when there is a misdiagnosed battery cell as they pass the voltage inflection point, the battery management apparatus 200 may decide misdiagnosis.

The battery management apparatus 200 may calculate an average of voltages of the plurality of battery cells 110, 120, 130, and 140 and a deviation dV of the voltage of each of the plurality of battery cells 110, 120, 130, and 140. The battery management apparatus 200 may determine an abnormal behavior of a voltage of at least one battery cell among the plurality of battery cells 110, 120, 130, and 140 by using the deviation of the voltage of each of the plurality of battery cells 110, 120, 130, and 140, thereby diagnosing a corresponding battery cell.

The battery management apparatus 200 may diagnose the battery cell by using deviation data of the voltage of each of the plurality of battery cells 110, 120, 130, and 140 except for noise voltage data suspected to be noise data among the deviation of the voltage of each of the plurality of battery cells 110, 120, 130, and 140. The battery management apparatus 200 may amplify the voltage deviation data of each of the plurality of battery cells 110, 120, 130, and 140 after excluding the noise voltage data among the deviations of the voltages of the plurality of battery cells 110, 120, 130, and 140. The battery management apparatus 200 may diagnose the abnormal battery cell suspected to be an abnormal voltage by using the amplified voltage deviation data of each of the plurality of battery cells 110, 120, 130, and 140.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

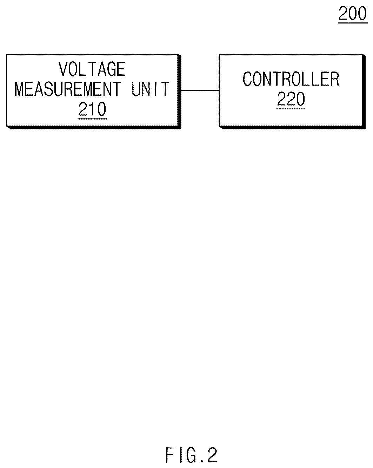

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a voltage measurement unit 210 and a controller 220.

The voltage measurement unit 210 may calculate the voltage of each of the plurality of battery cells 110, 120, 130, and 140. The voltage measurement unit 210 may calculate the voltage of each of the plurality of battery cells 110, 120, 130, and 140 for each unit time to calculate time-series data of the voltage of each of the plurality of battery cells 110, 120, 130, and 140. According to an embodiment, the voltage measurement unit 210 may continuously calculate voltage rise and drop and long-term relaxation data of the plurality of battery cells 110, 120, 130, and 140 in charging, an idle period after charging, discharging, and an idle period after discharging.

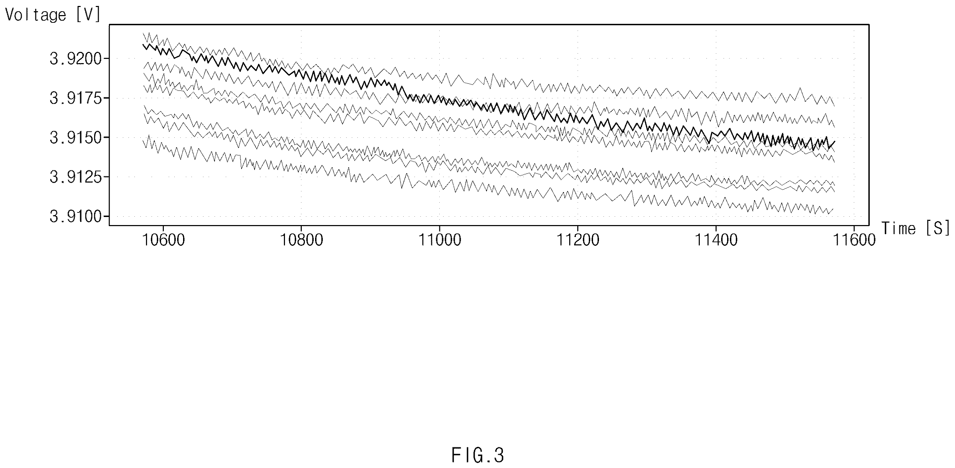

FIG. 3 is a graph showing a voltage of a battery cell according to an embodiment disclosed herein.

Referring to FIG. 3, the voltage measurement unit 210 may calculate the time-series data of the voltage of each of the plurality of battery cells 110, 120, 130, and 140 by measuring the voltages of the plurality of battery cells 110, 120, 130, and 140 in charging, an idle period after charging, discharging, and an idle period after discharging. The voltage measurement unit 210 may generate a graph indicating a voltage change of each of the plurality of battery cells 110, 120, 130, and 140 by measuring the voltage of each of the plurality of battery cells 110, 120, 130, and 140 for each unit time.

The controller 220 may calculate a moving average of the voltage of each of the plurality of battery cells 110, 120, 130, and 140. Herein, the moving average may be an average of some data extracted during movement on a window of a certain size among the entire data. Herein, the window may be a reference period for determining some of the entire data extracted for use. A start point of the window may be a point preceding the present point by a reference time, an end point of the window may be the present point. For example, when the window corresponds to one week, the controller 220 may extract data obtained during the recent one week from the present point from among the entire data.

The controller 220 may calculate the moving average of the voltage of each of the plurality of battery cells 110, 120, 130, and 140 by using voltage data extracted during movement in the window from among the entire voltage data of each of the plurality of battery cells 110, 120, 130, and 140. The controller 220 may calculate the continuous moving average of the voltage of each of the plurality of battery cells 110, 120, 130, and 140 by using voltage data continuously extracted during movement in the window from among the entire voltage data of each of the plurality of battery cells 110, 120, 130, and 140. For example, the controller 220 may calculate the moving average of the voltage of each of the plurality of battery cells 110, 120, 130, and 140 by applying any one of a simple moving average, a weighted moving average, or an exponential moving average (EMA) to the entire voltage data of each of the plurality of battery cells 110, 120, 130, and 140.

According to an embodiment, the controller 220 may calculate the EMA of the voltage of each of the plurality of battery cells 110, 120, 130, and 140 by applying the EMA to the entire voltage data of each of the plurality of battery cells 110, 120, 130, and 140. The EMA refers to a sort of weighted moving averaging in which a higher weight value is applied to the recent data, while using data of all the past periods.

The controller 220 may calculate a plurality of moving averages having different window sizes by using the voltage data of each of the plurality of battery cells 110, 120, 130, and 140. According to an embodiment, the controller 220 may calculate a long moving average having a long window length and a short moving average having a short window length by using the entire voltage data of each of the plurality of battery cells 110, 120, 130, and 140. For example, the window size of the long moving average may include 100 seconds, and the window size of the short moving average may include 10 seconds. For example, the controller 220 may calculate the long moving average of each of the plurality of battery cells 110, 120, 130, and 140 by using voltage data obtained during the recent 100 seconds from calculation using the voltage data of each of the plurality of battery cells 110, 120, 130, and 140, and calculate the short moving average of each of the plurality of battery cells 110, 120, 130, and 140 by using the voltage data obtained for the recent 10 seconds from the calculation.

The controller 220 may analyze a long voltage change trend and a short voltage change trend of each of the plurality of battery cells 110, 120, 130, and 140 by using continuous long moving average V_LMA and short moving average V_SMA of each of the plurality of battery cells 110, 120, 130, and 140. The controller 220 may diagnose whether a voltage of each of the plurality of battery cells is abnormal, by using the long moving average V_LMA and the short moving average V_SMA of each of the plurality of battery cells 110, 120, 130, and 140.

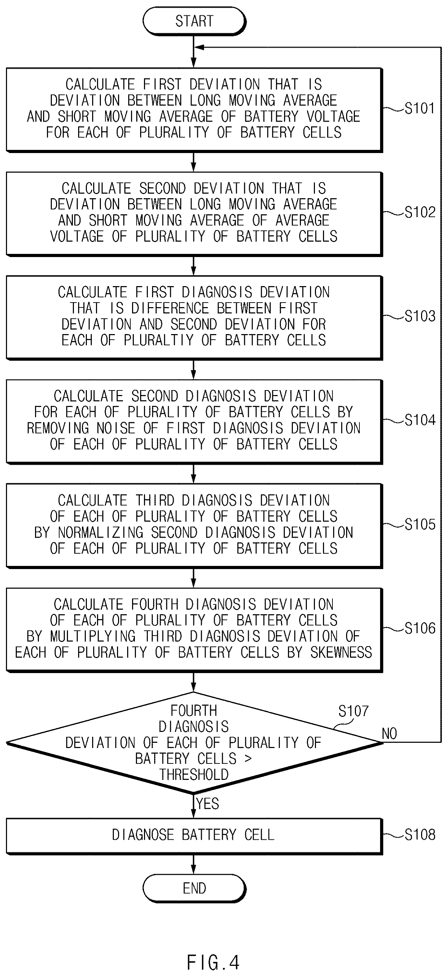

FIG. 4 is a flowchart illustrating a method of diagnosing a battery cell of a controller, according to an embodiment disclosed herein.

Hereinbelow, a battery cell diagnosis method of the controller will be described in detail with reference to FIG. 4.

In operation S101, the controller 220 may calculate a plurality of first deviations V_LMA - V_SMA which is a deviation of the long moving average V_LMA and the short moving average V_SMA of the voltage of each of the plurality of battery cells 110, 120, 130, and 140. In operation S101, the controller 220 may continuously calculate the first deviation V_LMA - V_SMA of each of the plurality of battery cells 110, 120, 130, and 140 calculated during a unit time. In operation S101, that is, the controller 220 may continuously calculate a deviation between a long behavior and a short behavior of each of the plurality of battery cells 110, 120, 130, and 140.

In operation S102, the controller 220 may calculate a long moving average ($V_{avg}LMA$) and a short moving average ($V_{avg}SMA$) of an average voltage V_avg of the plurality of battery cells 110, 120, 130, and 140. Herein, the average voltage V_avg of the plurality of battery cells 110, 120, 130, and 140 may include a mean or a median of the voltages of the plurality of battery cells 110, 120, 130, and 140.

In operation S102, the controller 220 may continuously calculate the average voltage V_avg of the plurality of battery cells 110, 120, 130, and 140 for each unit time, and calculate the long moving average ($V_{avg}LMA$) and the short moving average ($V_{avg}SMA$) of the average voltage V_avg of the plurality of battery cells 110, 120, 130, and 140 by using the average voltage V_avg of the plurality of battery cells 110, 120, 130, and 140. Herein, a window size of the long moving average ($V_{avg}LMA$) of the average voltage V_avg of the plurality of battery cells 110, 120, 130, and 140 may equal a window size of the long moving average V_LMA of the voltage of each of the plurality of battery cells 110, 120, 130, and 140. Herein, a window size of the short moving average ($V_{avg}SMA$) of the average voltage V_avg of the plurality of battery cells 110, 120, 130, and 140 may equal a window size of the short moving average V_SMA of the voltage of each of the plurality of battery cells 110, 120, 130, and 140.

In operation S102, the controller 220 may calculate a second deviation ($V_{avg}LMA-V_{avg}SMA$) that is a deviation between the long moving average ($V_{avg}LMA$) and the short moving average ($V_{avg}SMA$) of the average voltage V_avg of the plurality of battery cells 110, 120, 130, and 140. In operation S102, the controller 220 may continuously calculate the second deviation ($V_{avg}LMA$ - $V_{avg}SMA$) of the plurality of battery cells 110, 120, 130, and 140 for each unit time. That is, the controller 220 may calculate a deviation of a long behavior and a short behavior of the average voltage V_avg of the plurality of battery cells 110, 120, 130, and 140.

In operation S103, the controller 220 may calculate a first diagnosis deviation D1 of each of the plurality of battery cells 110, 120, 130, and 140, which is a deviation of the plurality of first deviations V_LMA - L_SMA and the second deviation ($V_{avg}LMA$-$V_{avg}SMA$).

In operation S103, specifically, the controller 220 may calculate the first diagnosis deviation D1 of each of the plurality of battery cells 110, 120, 130, and 140, based on Equation 1.

[Equation 1]

First Diagnosis Deviation D1 = Second Deviation – First Voltage

$$= (V_{avg\_LMA} - V_{avg\_SMA}) - (V\_LMA - V\_SMA)$$

Referring to Equation 1, the controller 220 may calculate the deviation of the plurality of first deviations V_LMA - V_SMA and the second deviation ($V_{avg}LMA$ - $V_{avg}SMA$) as the first diagnosis deviation D1 of each of the plurality of battery cells 110, 120, 130, and 140.

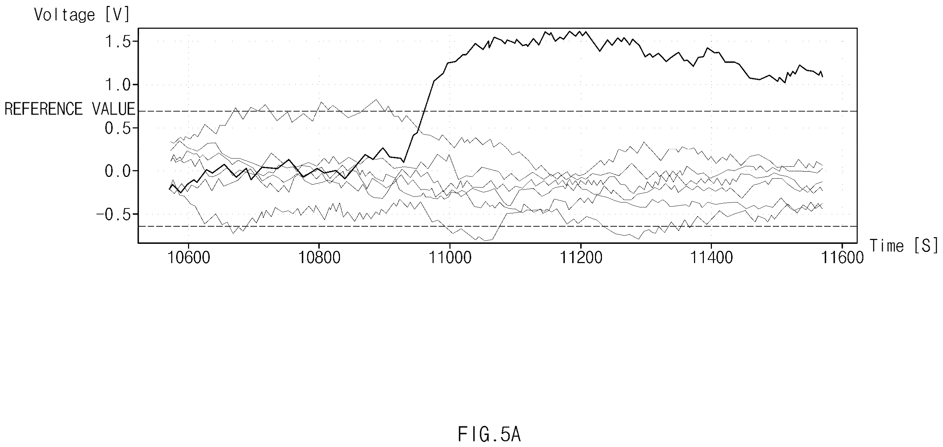

FIG. 5A is a graph showing a first diagnosis deviation of a battery cell according to an embodiment disclosed herein.

Referring to FIG. 5A, the controller 220 may continuously calculate the first diagnosis deviation D1 of each of the plurality of battery cells 110, 120, 130, and 140 for each unit time to generate a graph indicating a change in the first diagnosis deviation D1 of each of the plurality of battery cells 110, 120, 130, and 140.

That is, the controller 220 may calculate the first diagnosis deviation D1 of each of the plurality of battery cells 110, 120, 130, and 140 to compare a deviation of the long behavior and the short behavior of the voltage of each of the plurality of battery cells 110, 120, 130, and 140 with respect to a deviation of the long behavior and the short behavior of the average voltage V_avg of the plurality of battery cells 110, 120, 130, and 140.

Referring back to FIG. 4, in operation S104, the controller 220 may calculate a second diagnosis deviation D2 of each of the plurality of battery cells 110, 120, 130, and 140 by removing noise data from the first diagnosis deviation D1 of each of the plurality of battery cells 110, 120, 130, and 140.

In operation S104, specifically, the controller 220 may set a reference value for determining noise of the first diagnosis deviation D1 of each of the plurality of battery cells 110, 120, 130, and 140, based on Equation 2.

[Equation 2]

Reference Value = $\text{Max}\,[|V_{avg\_LMA} - V_{avg\_SMA}| * C1, C2]$

In operation S104, the controller 220 may set a maximum value Max between a value ($|V_{avg}LMA$ - $V_{avg}SMA|\times C1$) obtained by multiplying an absolute value of the second deviation ($V_{avg}LMA$-$V_{avg}SMA$) by a first threshold constant C1 and a second threshold constant C2 as a reference value for each of the plurality of battery cells 110, 120, 130, and 140. Herein, the first threshold constant C1 may include '0.1', and the second threshold constant C2 may include '0.4'. The first threshold constant C1 and the second threshold constant C2 may change according to a size and characteristics of voltage data of each of the plurality of battery cells 110, 120, 130, and 140.

In operation S104, the controller 220 may determine the first diagnosis deviation D1 less than or equal to the reference value among the first diagnosis deviation D1 of each of the plurality of battery cells 110, 120, 130, and 140 as noise data. In operation S104, the controller 220 may calculate the second diagnosis deviation D2 of each of the plurality of battery cells 110, 120, 130, and 140 by excluding the first diagnosis deviation D1 less than or equal to the reference value among the first diagnosis deviation D1 of each of the plurality of battery cells 110, 120, 130, and 140.

In operation S105, the controller 220 may calculate a third diagnosis deviation D3 by normalizing the second diagnosis deviation D2 of each of the plurality of battery cells 110, 120, 130, and 140.

In operation S105, specifically, the controller 220 may calculate the third diagnosis deviation D3 of each of the plurality of battery cells 110, 120, 130, and 140 by normalizing the second diagnosis deviation D2 of each of the plurality of battery cells 110, 120, 130, and 140, based on Equation 3 below.

Third Diagnosis Deviation = Second Diagnosis Deviation/ **Max [|V$_{avg}$_LMA - V$_{avg}$_SMA| * C3, C4]**     [Equation 3]

In operation S105, the controller 220 may calculate a maximum value Max between a value ($|V_{avg}LMA - V_{avg}SMA|\times C3$) obtained by multiplying the absolute value ($|V_{avg}LMA - V_{avg}SMA|$) of the second deviation by the third threshold constant C3 and a fourth threshold constant C4. The controller 220 may normalize the second diagnosis deviation D2 of each of the plurality of battery cells 110, 120, 130, and 140 by using the maximum value ($Max[|V_{avg}LMA-V_{avg}SMA|\times C3$, $C4$]) between the value obtained by multiplying the absolute value of the second deviation by the third threshold constant and the fourth threshold constant C4. Herein, the third threshold constant C3 may include '0.1', and the fourth threshold constant C4 may include '0.1', and the third threshold constant C3 and the fourth threshold constant C4 may change according to a size and characteristics of voltage data of each of the plurality of battery cells 110, 120, 130, and 140. In operation S105, the controller 220 may calculate, as the third diagnosis deviation D3 of each of the plurality of battery cells 110, 120, 130, and 140, a value obtained by normalizing the second diagnosis deviation D2 of each of the plurality of battery cells 110, 120, 130, and 140 by using the second deviation ($V_{avg}LMA-V_{avg}SMA$) indicating a behavior of the average voltage V_avg of the plurality of battery cells 110, 120, 130, and 140.

In operation S105, according to an embodiment, the controller 220 may normalize the second diagnosis deviation D2 of each of the plurality of battery cells 110, 120, 130, and 140 through a log operation. That is, the controller 220 may calculate, as the third diagnosis deviation D3 of each of the plurality of battery cells 110, 120, 130, and 140, a value obtained by normalizing the second diagnosis deviation D2 of each of the plurality of battery cells 110, 120, 130, and 140 through a log operation.

In operation S105, according to an embodiment, the controller 220 may set, as a normalization reference value, an average value D2_avg of the second diagnosis deviation D2 of each of the plurality of battery cells 110, 120, 130, and 140. In operation S105, the controller 220 may perform normalization by dividing the second diagnosis deviation D2 of each of the plurality of battery cells 110, 120, 130, and 140 by the average value D2_avg of the second diagnosis deviation D2, by using the average value D2_avg of the second diagnosis deviation as a normalization reference value. That is, the controller 220 may calculate, as the third diagnosis deviation D3 of each of the plurality of battery cells 110, 120, 130, and 140, a value obtained through normalization by dividing the second diagnosis deviation D2 of each of the plurality of battery cells 110, 120, 130, and 140 by the average value D2_avg of the second diagnosis deviation.

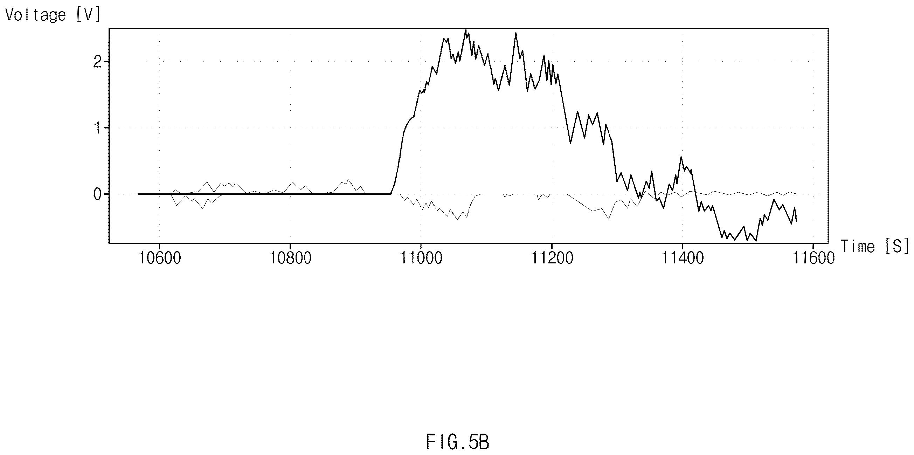

FIG. 5B is a graph showing the third diagnosis deviation D3 of a battery cell according to an embodiment disclosed herein.

Referring to FIG. 5B, the controller 220 may calculate the third diagnosis deviation D3 of each of the plurality of battery cells 110, 120, 130, and 140 by normalizing the second diagnosis deviation D2 of each of the plurality of battery cells 110, 120, 130, and 140, according to various embodiments.

The controller 220 may continuously calculate the third diagnosis deviation D3 of each of the plurality of battery cells 110, 120, 130, and 140 for each unit time to generate a graph indicating a change in the third diagnosis deviation D3 of each of the plurality of battery cells 110, 120, 130, and 140.

For example, the controller 220 may normalize the second diagnosis deviation D2 of each of the plurality of battery cells 110, 120, 130, and 140 by using the second deviation ($V_{avg}LMA-V_{avg}SMA$) indicating a behavior of the average voltage V_avg of the plurality of battery cells 110, 120, 130, and 140.

Referring back to FIG. 4, in operation S106, the controller 220 may calculate a skewness of the third diagnosis deviation D3 of each of the plurality of battery cells 110, 120, 130, and 140. In operation S106, specifically, the controller 220 may calculate the skewness of the third diagnosis deviation D3 of each of the plurality of battery cells 110, 120, 130, and 140, based on Equation 4 below.

Skewness = (Third Diagnosis Deviation D3 + Min[Third Diagnosis Deviation D3])/Third Diagnosis Deviation D3     [Equation 4]

In operation S106, referring to Equation 4, the controller 220 may calculate a skewness of each of the plurality of battery cells 110, 120, 130, and 140 by dividing a value, obtained by adding a minimum value (Min[Third Diagnosis Deviation D3]) of the third diagnosis deviation D3 of each of the plurality of battery cells 110, 120, 130, and 140 to the third diagnosis deviation D3 of each of the plurality of battery cells 110, 120, 130, and 140, by the third diagnosis deviation D3.

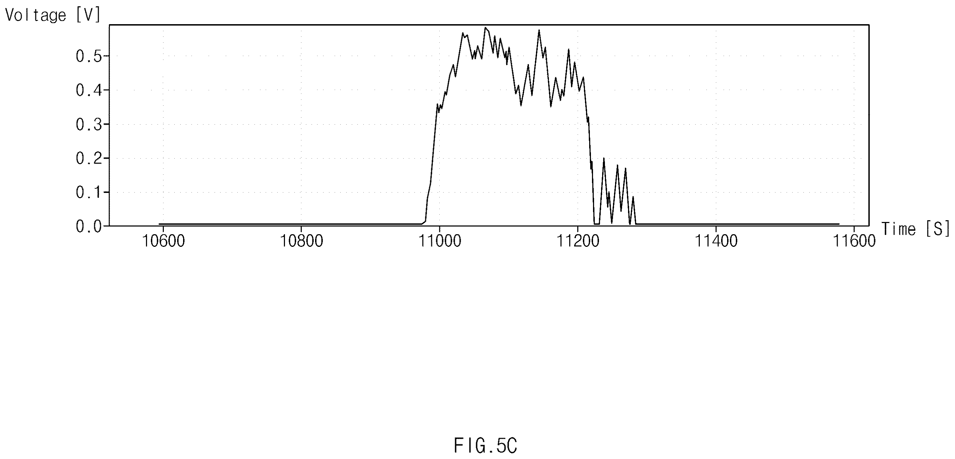

FIG. 5C is a graph showing a skewness of a third diagnosis deviation of a battery cell according to an embodiment disclosed herein.

Referring to FIG. 5C, the controller 220 may continuously calculate the skewness of the third diagnosis deviation D3 of each of the plurality of battery cells 110, 120, 130, and 140 for each unit time to generate a graph indicating a change in the skewness of the third diagnosis deviation D3 of each of the plurality of battery cells 110, 120, 130, and 140.

Referring back to FIG. 4, in operation S106, the controller 220 may calculate a fourth diagnosis deviation D4 of each of the plurality of battery cells 110, 120, 130, and 140 by reflecting the skewness to the third diagnosis deviation D3 of each of the plurality of battery cells 110, 120, 130, and 140. To be more specific, the controller 220 may calculate the fourth diagnosis deviation D4 of each of the plurality of battery cells 110, 120, 130, and 140, based on Equation 5.

[Equation 5]

$$\text{Fourth Diagnosis Deviation D4} = \text{Third Diagnosis Deviation D3} * \text{Skewness}$$

In operation S106, the controller 220 may calculate the fourth diagnosis deviation D4 of each of the plurality of battery cells 110, 120, 130, and 140 by multiplying the third diagnosis deviation D3 of each of the plurality of battery cells 110, 120, 130, and 140 by the skewness.

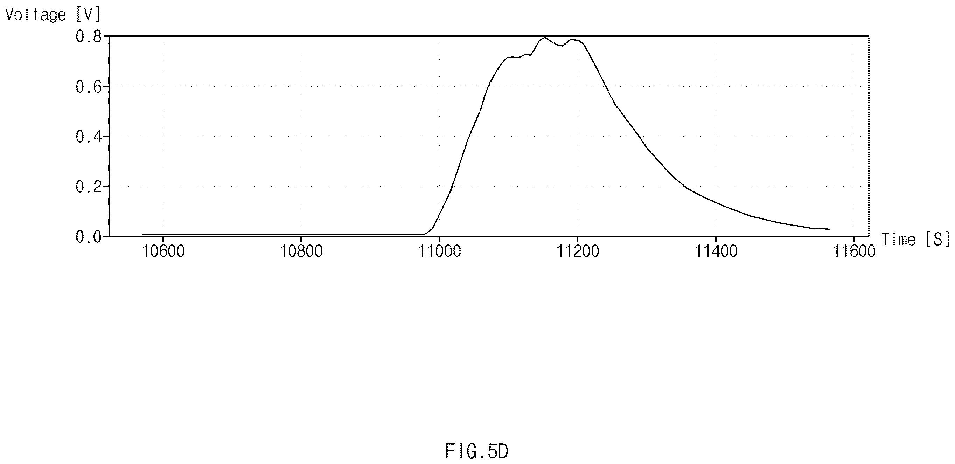

FIG. 5D is a graph showing a fourth diagnosis deviation of a battery cell according to an embodiment disclosed herein.

Referring to FIG. 5D, the controller 220 may continuously calculate the fourth diagnosis deviation D4 of each of the plurality of battery cells 110, 120, 130, and 140 for each unit time to generate a graph indicating a change in the fourth diagnosis deviation D4 of each of the plurality of battery cells 110, 120, 130, and 140.

Referring back to FIG. 4, in operation S107, the controller 220 may determine whether the fourth diagnosis deviation D4 of each of the plurality of battery cells 110, 120, 130, and 140 exceeds a threshold value. Herein, the threshold value may be defined as a criterion for determining 'abnormality' because an extreme result is output. That is, the threshold value may be defined as a criterion indicating a degree to which data contradicts a particular statistical model. The controller 220 may determine a battery cell as having an abnormal behavior of a voltage when the fourth diagnosis deviation D4 of the battery cell among the plurality of battery cells 110, 120, 130, and 140 exceeds the threshold value.

In operation S108, the controller 220 may diagnose at least one of the plurality of battery cells 110, 120, 130, and 140, based on whether the fourth diagnosis deviation D4 of each of the plurality of battery cells 110, 120, 130, and 140 exceeds the threshold value. In operation S108, when the fourth diagnosis deviation D4 of at least one of the plurality of battery cells 110, 120, 130, and 140 exceeds the threshold value, the controller 220 may diagnose the battery cell.

In operation S108, according to an embodiment, when the fourth diagnosis deviation D4 of at least one of the plurality of battery cells 110, 120, 130, and 140 exceeds the threshold value, the controller 220 may increase a diagnosis count value of the at least one battery cell.

In operation S108, according to an embodiment, when the diagnosis count value of at least one of the plurality of battery cells 110, 120, 130, and 140 is greater than or equal to the threshold value, the controller 220 may diagnose the at least one battery cell.

After diagnosing the at least one of the plurality of battery cells 110, 120, 130, and 140, the controller 220 may track and monitor whether a defect of the battery cell, such as internal short-circuit, external short-circuit, lithium precipitation, etc., occurs.

When the controller 220 determines that a defect occurs in the battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

As described above, the battery management apparatus 200 according to an embodiment disclosed herein may accurately diagnose an abnormal battery cell by removing noise of a deviation between a long moving average and a short moving average of a voltage of a battery cell.

In a conventional battery management apparatus, an abnormal behavior signal of a voltage of each battery cell is distorted using a deviation of a voltage of each battery cell with respect to an average voltage of battery cells and there is a possibility of misdiagnosis due to noise data, but the battery management apparatus 200 according to an embodiment disclosed herein may minimize distortion of the voltage of the battery cell by using the deviation of the long moving average value and the short moving average of the voltage of each battery cell, remove noise data, and amplifying the voltage behavior of the abnormal battery cell by applying the skewness of the voltage of the battery cell, thereby improving the accuracy of diagnosis.

The battery management apparatus 200 may early diagnose the battery cell having the abnormal voltage behavior occurring by using the deviation of the long moving average and the short moving average of the voltage of the battery cell, thereby securing safety and reliability of the battery cell energy. In addition, the battery management apparatus 200 may does not need separation of the battery cell because of diagnosing the battery cell having the abnormal voltage behavior occurring in a state of the battery cell mounted on the vehicle, thereby rapidly and conveniently diagnosing the battery cell.

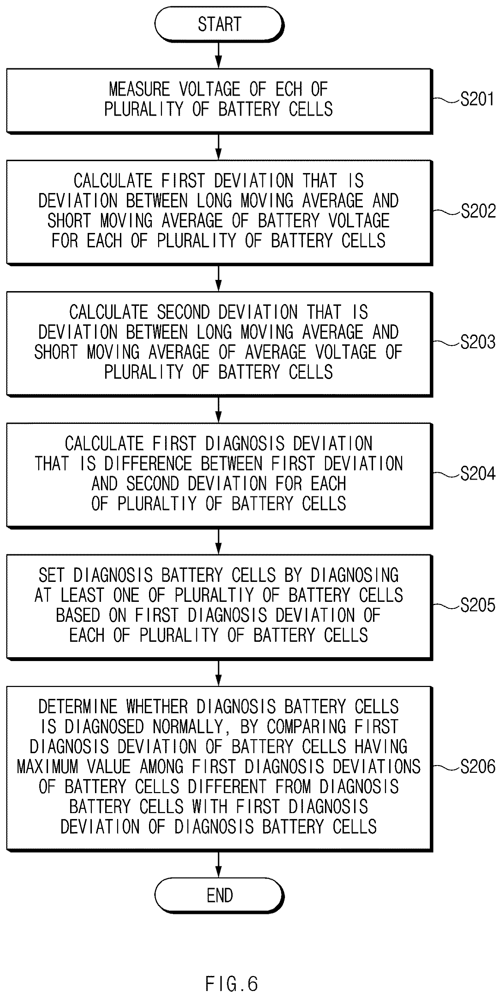

FIG. 6 is a flowchart of a battery management apparatus according to another embodiment disclosed herein. Operations shown in FIG. 6 may be performed by the battery management apparatus 200 of FIG. 2.

Referring to FIG. 6, in operation S201, the voltage measurement unit 210 may measure a voltage of each of a plurality of battery cells.

In operation S202, the controller 220 may calculate a first deviation that is a deviation between the long moving average and the short moving average of the voltage of each of the plurality of battery cells. For example, operation S202 may be substantially the same as operation S102 of FIG. 4.

In operation S203, the controller 220 may calculate a second deviation that is a deviation between the long moving average and the short moving average of the average voltage of the plurality of battery cells. For example, operation S203 may be substantially the same as operation S103 of FIG. 4.

In operation S204, the controller 220 may calculate a first diagnosis deviation that is a difference between the first deviation and the second deviation for each of the plurality of battery cells. For example, operation S204 may be substantially the same as operation S104 of FIG. 4.

In operation S205, the controller 220 may diagnose at least one of the plurality of battery cells based on the first diagnosis deviation of each of the plurality of battery cells to set a diagnosis battery cell. For example, the controller 220 may set a battery cell having the first diagnosis deviation greater than or equal to a predetermined value as the diagnosis battery cell.

According to an embodiment, the controller 220 may calculate the second diagnosis deviation of each of the plurality of battery cells based on a reference value obtained by multiplying the second deviation among the first diagnosis deviations of the plurality of respective battery cells by a threshold constant, and diagnose at least one of the plurality of battery cells based on the second diagnosis deviation of each of the plurality of battery cells, thereby setting the diagnosis battery cell.

According to an embodiment, the controller 220 may set a maximum value between a value obtained by multiplying the second deviation by the first threshold constant and the second threshold constant and exclude the first diagnosis deviation less than or equal to the reference value from the first diagnosis deviations of the plurality of respective battery cells, thereby calculating the second diagnosis deviation of each of the plurality of battery cells. The controller 220 may perform normalization by dividing the second diagnosis deviation of each of the plurality of battery cells by the maximum value between a value obtained by multiplying the second deviation by the third threshold constant and the fourth threshold constant, thereby calculating the third diagnosis deviation of each of the plurality of battery cells. The controller 220 may calculate a skewness of each of the plurality of battery cells by dividing a value, obtained by adding a minimum value of the third diagnosis deviation of each of the plurality of battery cells to the third diagnosis deviation of each of the plurality of battery cells, by the third diagnosis deviation, calculate the fourth diagnosis deviation of each of the plurality of battery cells by multiplying the third diagnosis deviation of each of the plurality of battery cells by the skewness, diagnose at least one of the plurality of battery cells based on whether the fourth diagnosis deviation of each of the plurality of battery cells exceeds the threshold value to set the diagnosis battery cell.

That is, according to various embodiments, in operation S205, the controller 220 may diagnose the plurality of battery cells based on any one of the first diagnosis deviation, or the second diagnosis deviation, the third diagnosis deviation, or the fourth diagnosis deviation based on the first diagnosis deviation to set the diagnosis battery cell.

In operation S206, the controller 220 may determine whether the diagnosis battery cell is diagnosed normally, by comparing the first diagnosis deviation of the battery cell having the maximum value among the first diagnosis deviations of the battery cells different from the diagnosis battery cell with the first diagnosis deviation of the diagnosis battery cell. For example, the controller 220 may determine that the diagnosis battery cell is diagnosed normally, when a product of the first diagnosis deviation of the diagnosis battery cell and a set value exceeds the first diagnosis deviation of the battery cell having the maximum value. In another example, the controller 220 may determine that the diagnosis battery cell is misdiagnosed, when a product of the first diagnosis deviation of the diagnosis battery cell and the set value is less than or equal to the first diagnosis deviation of the battery cell having the maximum value.

According to an embodiment, the controller 220 may update the maximum value of the first diagnosis deviations of the battery cells different from the diagnosis battery cell for each reference time. For example, the controller 220 may calculate the first diagnosis deviation of each of the plurality of battery cells for each reference time and update the first diagnosis deviation of the battery cell having the maximum value among the first diagnosis deviations of the battery cells different from the diagnosis battery cell for each reference time. That is, the controller 220 may update the first diagnosis deviation of the battery cell having the maximum value among the first diagnosis deviations with the maximum value between the previously stored maximum value and the newly calculated first diagnosis deviation.

According to an embodiment, the controller 220 may also store the voltage of the battery cell having the maximum value among the first diagnosis deviations of the battery cells different from the diagnosis battery cell. For example, when the first battery cell is different from the diagnosis battery cell and the first diagnosis deviation of the first battery cell has the maximum value, the controller 220 may store the first diagnosis deviation of the first battery cell and the voltage of the first battery cell correspondingly to each other. In addition, the controller 220 may also store identification information of the first battery cell further correspondingly.

According to an embodiment, when the stored voltage of the first battery cell is less than the voltage of the battery cell having the minimum voltage among the plurality of battery cells, the controller 220 may initialize the stored value. For example, when the stored voltage of the first battery cell is less than the voltage of the battery cell having the minimum voltage among the plurality of battery cells, it corresponds to a case where all battery cells pass the voltage inflection point, such that the controller 220 may initialize the stored value at the voltage inflection point and store a new maximum value of the first diagnosis deviation.

According to an embodiment, the controller 220 may calculate the first diagnosis deviation of the diagnosis battery cell for each reference time and update the maximum value of the first diagnosis deviation of the diagnosis battery cell for each reference time. For example, the controller 220 may update the maximum value of the first diagnosis deviation of the diagnosis battery cell for each reference time to update the maximum value of the first diagnosis deviation calculated in relation to the diagnosis battery cell. According to an embodiment, the controller 220 may store the maximum value of the first diagnosis deviation of the diagnosis battery cell and the voltage of the diagnosis battery cell at a corresponding point, correspondingly to each other. In addition, the controller 220 may also store identification information of the diagnosis battery cell further correspondingly.

According to an embodiment, the controller 220 may determine that the diagnosis battery cell is diagnosed normally, when the minimum value among the voltages of the plurality of battery cells is greater than the voltage at the time of diagnosis of the diagnosis battery cell and diagnosis of the diagnosis battery cell is not determined as misdiagnosis.

According to an embodiment, the controller 220 may determine whether the diagnosis battery cell is diagnosed normally, by updating the maximum value among the first diagnosis deviations of the battery cells different from the diagnosis battery cell for each unit time and comparing the updated maximum value with the first diagnosis deviation of the diagnosis battery cell.

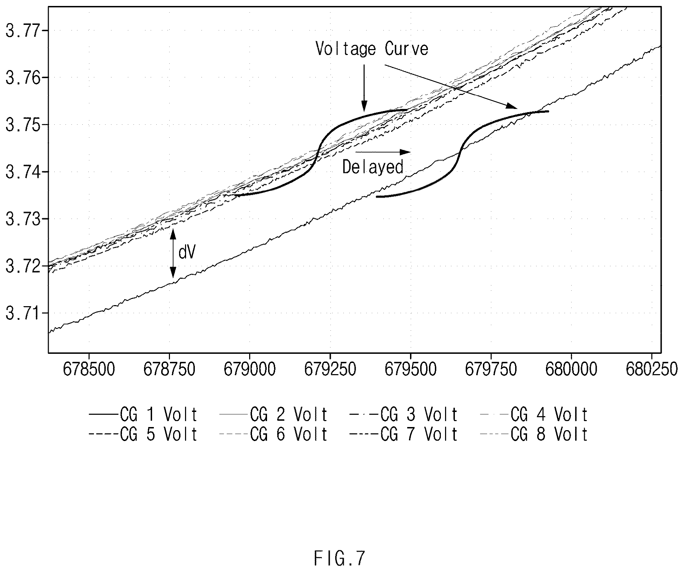

FIG. 7 is a diagram for describing a difference in voltage inflection point between a plurality of battery cells according to another embodiment disclosed herein.

Referring to FIG. 7, the plurality of battery cells may have different voltages during charging. In this case, there may be a situation where the plurality of battery cells have the same voltage in different times during charging, such that times when the plurality of battery cells pass the voltage inflection point may also be different, resulting in a case where the battery management apparatus 200 performing deviation-based diagnosis misdiagnoses a battery at a point of passing the voltage inflection point.

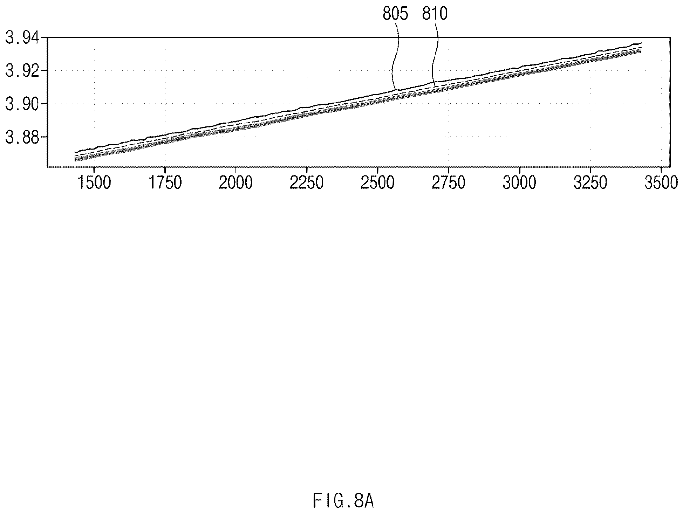

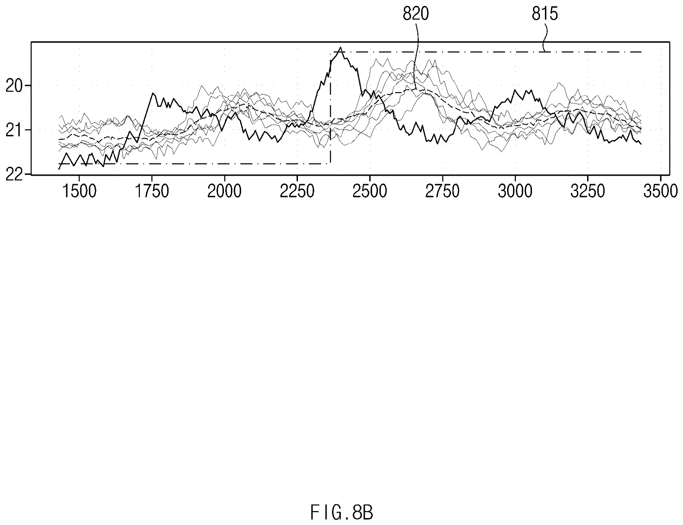

FIGS. 8A and 8B are views for describing a difference in first diagnosis deviation based on a difference in voltage inflection point between battery cells, according to another embodiment disclosed herein.

Referring to FIG. 8A, when the plurality of battery cells are being charged, a voltage deviation may occur due to a battery cell 805 having the highest voltage and the other battery cell 810.

Referring to FIG. 8B, the battery cell 805 having the highest voltage may have a high first diagnosis deviation 815. In this case, the other battery cell 810 may not reach a voltage inflection point, having a lower first diagnosis deviation 820. Thus, the battery management apparatus 200 diagnosing the battery cell based on the first diagnosis deviation may diagnose that abnormality occurs in the battery cell 805 having the highest voltage.

However, when the other battery cell 810 passes the voltage inflection point over time, the battery cell 810 has a first diagnosis deviation similar to the high first diagnosis deviation 815. That is, the battery management apparatus 200 according to another embodiment of the present disclosure may provide a diagnosis method capable of preventing misdiagnosis due to a voltage inflection point.

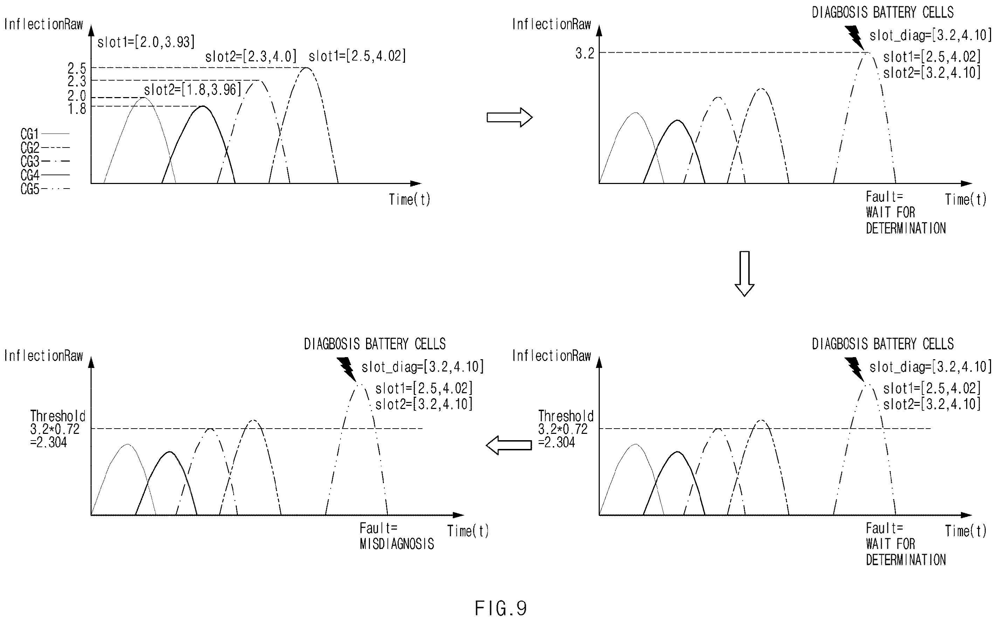

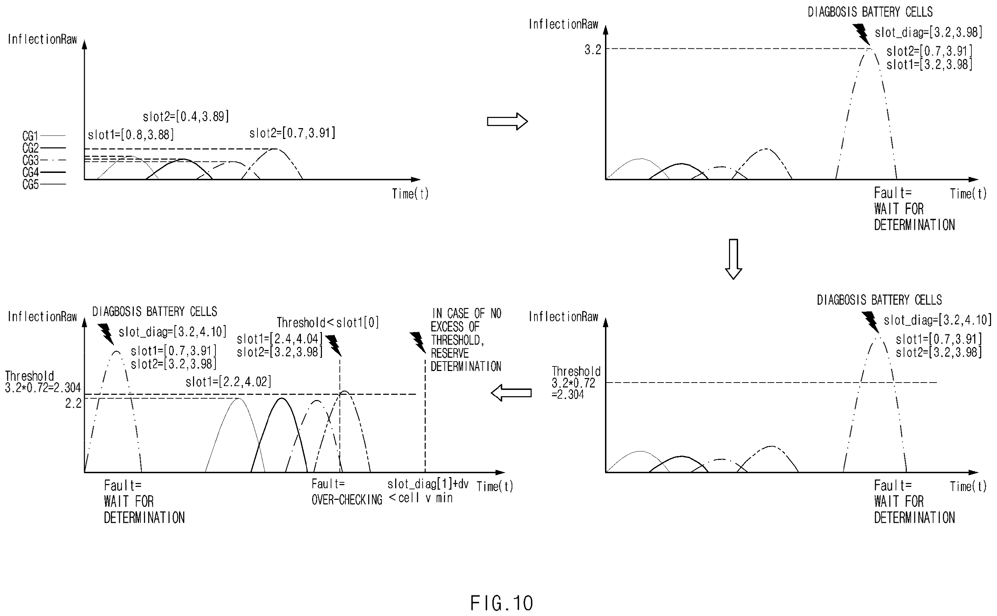

FIGS. 9 and 10 are views for describing a misdiagnosis detection method of a battery management apparatus, according to another embodiment disclosed herein.

Referring to FIG. 9, the controller 220 of the battery management apparatus 200 according to another embodiment disclosed herein may store a maximum value among first diagnosis deviations of the plurality of respective battery cells. For example, the controller 220 may store the maximum value among the first diagnosis deviations of the plurality of respective battery cells for each reference time. According to an embodiment, the controller 220 may store the maximum value among the first diagnosis deviations of the plurality of respective battery cells alternately for slot 1 and slot 2. That is, when the first diagnosis deviation higher than values stored in slot 1 and slot 2 is calculated, the controller 220 may update a slot having the lower first diagnosis deviation between the first diagnosis deviations stored in slot 1 and slot 2. In the graph shown in FIG. 9, slot 1 = [2.0, 3.93] may mean a first diagnosis deviation of 2.0 and a voltage of 3.93. That is, the controller 220 may store the first diagnosis deviation having the maximum value and the voltage of the battery cell at a corresponding point in each slot, correspondingly to each other.

The controller 220 of the battery management apparatus 200 may set a diagnosis battery cell. In this case, the controller 220 may store the first diagnosis deviation and the voltage of the diagnosis battery cell. As the first diagnosis deviation of the diagnosis battery cell is greater than the first diagnosis deviations of other battery cells different from the diagnosis battery cell, the first diagnosis deviation of the diagnosis battery cell may be stored in any one of two slots and the maximum value among the first diagnosis deviations of the battery cells different from the diagnosis battery cell may be stored in the other slot.

The controller 220 of the battery management apparatus 200 may determine whether the diagnosis battery cell is diagnosed normally, based on the first diagnosis deviation of the diagnosis battery cell and the maximum value among the first diagnosis deviations of the battery cells different from the diagnosis battery cell. For example, the maximum value (2.5) among the first diagnosis deviations of the battery cells different from the diagnosis battery cell is greater than a product of the first diagnosis deviation (3.2) of the diagnosis battery cell and the set value (0.72) (3.2*0.72 = 2.304 < 2.5), the controller 220 may determine that the diagnosis battery cell is misdiagnosed.

That is, the controller 200 may store the maximum value among the first diagnosis deviations of the plurality of battery cells for each reference time and determine whether the diagnosis battery cell is misdiagnosed, by comparing the stored maximum value with the first diagnosis deviation of the diagnosis battery cell.

While it is shown in FIG. 9 that the diagnosis battery cell is misdiagnosed based on the maximum value of the first diagnosis deviation preceding the time at which the diagnosis battery cell is diagnosed, the battery management apparatus 200 may continuously calculate the first diagnosis deviation of the plurality of battery cells for each reference time and update the maximum value to reserve data even when the diagnosis battery cell is determined to be misdiagnosed.

Referring to FIG. 10, the controller 220 of the battery management apparatus 200 according to another embodiment disclosed herein may store a maximum value among first diagnosis deviations of the plurality of respective battery cells.

The controller 220 may determine whether the diagnosis battery cell is diagnosed normally, by comparing the first diagnosis deviation of the diagnosis battery cell with the maximum value of the first diagnosis deviations of the battery cells different from the diagnosis battery cell. In this case, the controller 220 may preferentially compare the maximum value among the first diagnosis deviations preceding the time at which the diagnosis battery cell is diagnosed, with the first diagnosis deviation of the diagnosis battery cell, and wait for determination of diagnosis of the diagnosis battery cell to compare the maximum value among the first diagnosis deviations following the time at which the diagnosis battery cell is diagnosed, when it is not determined that the diagnosis battery cell is misdiagnosed.

The controller 220 may wait for determination of diagnosis of the diagnosis battery cell until the minimum value among the voltages of the plurality of battery cells is higher than the voltage at the time of the diagnosis of the diagnosis battery cell. According to an embodiment, when the minimum value among the voltages of the plurality of battery cells is higher than the voltage at the time of the diagnosis of the diagnosis battery cell and it is not determined that the diagnosis battery cell is misdiagnosed, the controller 220 may determine that the diagnosis battery cell is diagnosed normally. According to an embodiment, the controller 220 may wait for determination of diagnosis of the diagnosis battery cell until the minimum value among the voltages of the plurality of battery cells is higher than a set voltage value.

The controller 220 may store the maximum value among the first diagnosis deviations of the battery cells different from the diagnosis battery cell for each reference time when the minimum value among the voltages of the plurality of battery cells is greater than or equal to the voltage at the time of diagnosis of the diagnosis battery cell.

The controller 220 may determine whether the diagnosis battery cell is diagnosed normally, by comparing the maximum value among the first diagnosis deviations of the battery cells different from the diagnosis battery for each reference time with the first diagnosis deviation of the diagnosis battery cell. That is, in FIG. 10, in a state where the minimum value (3.98 V) among the voltages of the plurality of battery cells is less than the voltage (4.1 V) at the time of diagnosis of the diagnosis battery cell, the maximum value (2.4) among the first diagnosis deviations of the battery cells different from the diagnosis battery cell is calculated, which is greater than a product of the first diagnosis deviation (3.2) of the diagnosis battery cell and the set value (0.72), such that the controller 220 may determine that the diagnosis battery cell is misdiagnosed.

Thus, the battery management apparatus 200 according to another embodiment disclosed herein may distinguish a voltage inflection point commonly appearing according to characteristics of a cell and a voltage inflection point caused by a defect, thereby preventing over-checking and improving a diagnosis rate.

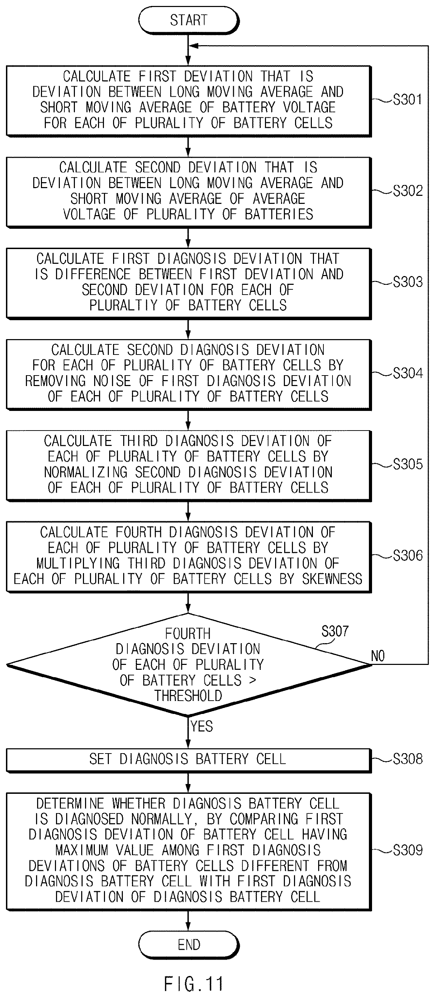

FIG. 11 is a view for describing an operating method of a battery management apparatus, according to another embodiment disclosed herein. Operations shown in FIG. 11 may be performed by the battery management apparatus 200 of FIG. 2.

According to an embodiment, the measurement unit 210 may measure a voltage of each of a plurality of battery cells before operation S301. For example, the measurement unit 210 may measure a voltage of each of the plurality of battery cells for each reference time when the plurality of battery cells are being charged.

Referring to FIG. 11, in operation S301, the controller 220 may calculate a first deviation that is a deviation between the long moving average and the short moving average of the battery voltage of each of the plurality of battery cells.

In operation S302, the controller 220 may calculate a second deviation that is a deviation between the long moving average and the short moving average of the average voltage of the plurality of batteries.

In operation S303, the controller 220 may calculate a first diagnosis deviation that is a difference between the first deviation and the second deviation for each of the plurality of battery cells.

In operation S304, the controller 220 may calculate a second diagnosis deviation for each of the plurality of battery cells by removing noise of the first diagnosis deviation of each of the plurality of battery cells.

In operation S305, the controller 220 may calculate a third diagnosis deviation of each of the plurality of battery cells by normalizing the second diagnosis deviation of each of the plurality of battery cells.

In operation S306, the controller 220 may calculate a fourth diagnosis deviation of each of the plurality of battery cells by multiplying the third diagnosis deviation of each of the plurality of battery cells by a skewness.

In operation S307, the controller 220 may compare the fourth diagnosis deviation of each of the plurality of battery cells with a threshold.

According to an embodiment, operations S304 to S307 may not be performed and operation S308 may be performed.

In operation S308, the controller 220 may set a diagnosis battery cell. According to an embodiment, the controller 220 may set the diagnosis battery cell based on the first diagnosis deviation. According to another embodiment, the controller 220 may set the diagnosis battery cell based on any one of the second to fourth diagnosis deviations.

In operation S309, the controller 220 may determine whether the diagnosis battery cell is diagnosed normally, by comparing the first diagnosis deviation of the battery cell having the maximum value among the first diagnosis deviations of the battery cells different from the diagnosis battery cell with the first diagnosis deviation of the diagnosis battery cell. According to an embodiment, in operation S309, the controller 220 may determine that the diagnosis battery cell is diagnosed normally when a product of the first diagnosis deviation of the diagnosis battery cell and a set value exceeds the first diagnosis deviation of the battery cell having the maximum value, and determine that the diagnosis battery cell is misdiagnosed when the product of the first diagnosis deviation of the diagnosis battery cell and the set value is less than the first diagnosis deviation of the battery cell having the maximum value.

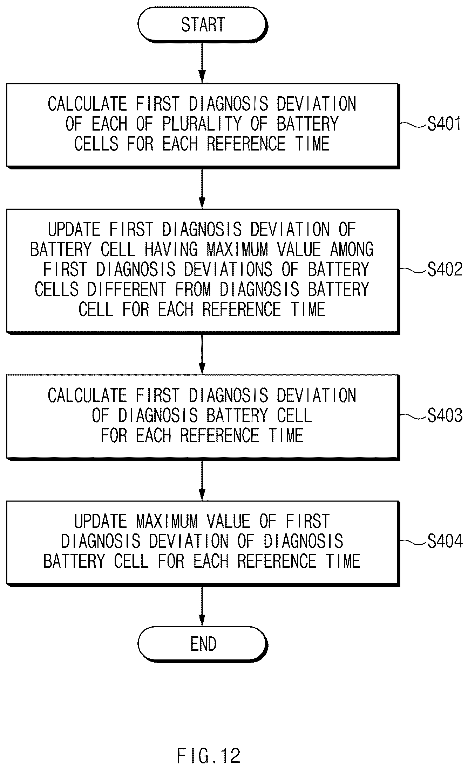

FIG. 12 is a view for describing in detail an operating method of a battery management apparatus, according to another embodiment disclosed herein. Operations shown in FIG. 12 may be performed by the battery management apparatus 200 of FIG. 2.

Referring to FIG. 12, in operation S401, the controller 220 may calculate the first diagnosis deviation of each of the plurality of battery cells for each reference time.

In operation S402, the controller 220 may update the first diagnosis deviation of the battery cell having the maximum value among the first diagnosis deviations of the battery cells different from the diagnosis battery cell, for each reference time. That is, the controller 220 may update and store the maximum value among the first diagnosis deviations of the battery cells different from the diagnosis battery cell before or after the time at which the diagnosis battery cell is diagnosed.

In operation S403, the controller 220 may calculate the first diagnosis deviation of the diagnosis battery cell for each reference time.

In operation S404, the controller 220 may update the maximum value of the first diagnosis deviation of the diagnosis battery cell for each reference time.

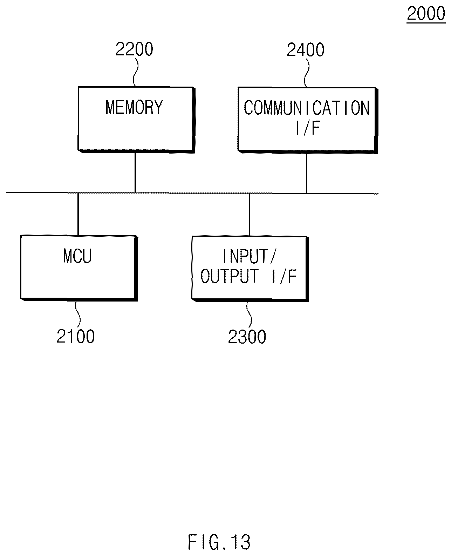

FIG. 13 is a block diagram showing a hardware configuration of a computing system for performing an operating method of a battery management apparatus, according to an embodiment disclosed herein.

Referring to FIG. 13, a computing system 2000 according to an embodiment disclosed herein may include an MCU 2100, a memory 2200, an input/output I/F 2300, and a communication I/F 2400.

The MCU 2100 may be a processor that executes various programs (e.g., a battery voltage deviation analysis program, etc.) stored in the memory 2200, processes various data through these programs, and perform the above-described functions of the battery management apparatus 200 shown in FIG. 2.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for voltage deviation diagnosis, misdiagnosis determination, and abnormality diagnosis or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

**Claims**

1. A battery management apparatus comprising:

   a voltage measurement unit configured to measure a voltage of each of a plurality of battery cells; and
   a controller configured to:

   calculate a first deviation, which is a deviation between a long moving average and a short moving average of a battery cell voltage of each of the plurality of battery cells, calculate a second deviation, which is a deviation between a long moving average and a short moving average of an average voltage of the plurality of battery cells, and calculate a first diagnosis deviation between the first deviation and the second deviation for each of the plurality of battery cells;
   setting a diagnosis battery cell by diagnosing at least one of the plurality of battery cells based on the first diagnosis deviation of each of the plurality of battery cells; and
   determine whether the diagnosis battery cell is diagnosed normally, by comparing a first diagnosis deviation of a battery cell having a maximum value among first diagnosis deviations of battery cells different from the diagnosis battery cell with the first diagnosis deviation of the diagnosis battery cell.

2. The battery management apparatus of claim 1, wherein the controller is further configured to:

   determine that the diagnosis battery cell is diagnosed normally, when a product of the first diagnosis deviation of the diagnosis battery cell and a set value exceeds the first diagnosis deviation of the battery cell having the maximum value; and
   determine that the diagnosis battery cell is misdiagnosed, when the product of the first diagnosis deviation of the diagnosis battery cell and the set value is less than or equal to the first diagnosis deviation of the battery cell having the maximum value.

3. The battery management apparatus of claim 1, wherein the controller is further configured to:

   calculate the first diagnosis deviation of each of the plurality of battery cells for each reference time; and
   update the first diagnosis deviation of the battery cell having the maximum value among the first diagnosis deviations of the battery cells different from the diagnosis battery cell, for each reference time.

4. The battery management apparatus of claim 1, wherein the controller is further configured to:

   calculate the first diagnosis deviation of each of the plurality of battery cells for each reference time; and
   update a maximum value of the first diagnosis deviation of the diagnosis battery cell for each reference time.

5. The battery management apparatus of claim 1, wherein the controller is further configured to determine that the diagnosis battery cell is diagnosed normally, when a minimum value among the voltages of the plurality of battery cells is greater than a voltage at the time of diagnosis of the diagnosis battery cell and diagnosis of the diagnosis battery cell is not determined as misdiagnosis.

6. The battery management apparatus of claim 1, wherein the controller is further configured to:

   update the maximum value among the first diagnosis deviations of the battery cells different from the diagnosis battery cell for each reference time; and
   determine whether the diagnosis battery cell is diagnosed normally by comparing the updated maximum value with the first diagnosis deviation of the diagnosis battery cell.

7. The battery management apparatus of claim 1, wherein the controller is further configured to:

calculate a second diagnosis deviation of each of the plurality of battery cells based on a reference value obtained by multiplying the second deviation among the first diagnosis deviations of the plurality of respective battery cells by a threshold constant; and
set the diagnosis battery cell by diagnosing at least one of the plurality of battery cells based on the second diagnosis deviation of each of the plurality of battery cells.

8. The battery management apparatus of claim 7, wherein the controller is further configured to:

set, as the reference value, a maximum value between a value, obtained by multiplying the second deviation by a first threshold constant, and a second threshold constant;
calculate a second diagnosis deviation of each of the plurality of battery cells by excluding a first diagnosis deviation less than or equal to the reference value among the first diagnosis deviations of the plurality of respective battery cells;
perform normalization by dividing the second diagnosis deviation of each of the plurality of battery cells by a maximum value between a value, obtained by multiplying the second deviation by a third threshold constant, and a fourth threshold constant to calculate a third diagnosis deviation of each of the plurality of battery cells;
calculate a skewness of each of the plurality of battery cells by dividing a value, obtained by adding a minimum value among the third diagnosis deviations of the plurality of respective battery cells, to the third diagnosis deviation of each of the plurality of battery cells;
calculate a fourth diagnosis deviation of each of the plurality of battery cells by multiplying the skewness to the third diagnosis deviation of each of the plurality of battery cells; and
set the diagnosis battery cell by diagnosing at least one of the plurality of battery cells based on whether the fourth diagnosis deviation of each of the plurality of battery cells exceeds a threshold.

9. An operating method of a battery management apparatus, the operating method comprising:

measuring a voltage of each of a plurality of battery cells;
calculating a first deviation, which is a deviation between a long moving average and a short moving average of a battery cell voltage of each of the plurality of battery cells, calculating a second deviation, which is a deviation between a long moving average and a short moving average of an average voltage of the plurality of battery cells, and calculating a first diagnosis deviation between the first deviation and the second deviation for each of the plurality of battery cells;
setting a diagnosis battery cell by diagnosing at least one of the plurality of battery cells based on the first diagnosis deviation of each of the plurality of battery cells; and
determining whether the diagnosis battery cell is diagnosed normally, by comparing a first diagnosis deviation of a battery cell having a maximum value among first diagnosis deviations of battery cells different from the diagnosis battery cell with the first diagnosis deviation of the diagnosis battery cell.

10. The operating method of claim 9, wherein the determining of whether the diagnosis battery cell is diagnosed normally, by comparing the first diagnosis deviation of the battery cell having the maximum value among first diagnosis deviations of battery cells different from the diagnosis battery cell with the first diagnosis deviation of the diagnosis battery cell comprises:

determining that the diagnosis battery cell is diagnosed normally, when a product of the first diagnosis deviation of the diagnosis battery cell and a set value exceeds the first diagnosis deviation of the battery cell having the maximum value; and
determining that the diagnosis battery cell is misdiagnosed, when the product of the first diagnosis deviation of the diagnosis battery cell and the set value is less than or equal to the first diagnosis deviation of the battery cell having the maximum value.

11. The operating method of claim 9, further comprising:

calculating the first diagnosis deviation of each of the plurality of battery cells for each reference time; and
updating the first diagnosis deviation of the battery cell having the maximum value among the first diagnosis deviations of the battery cells different from the diagnosis battery cell, for each reference time.

**12.** The operating method of claim 9, further comprising:

calculating the first diagnosis deviation of each of the plurality of battery cells for each reference time; and
updating a maximum value of the first diagnosis deviation of the diagnosis battery cell for each reference time.

**13.** The operating method of claim 9, wherein the determining of whether the diagnosis battery cell is diagnosed normally, by comparing the first diagnosis deviation of the battery cell having the maximum value among first diagnosis deviations of battery cells different from the diagnosis battery cell with the first diagnosis deviation of the diagnosis battery cell comprises:

updating the maximum value among the first diagnosis deviations of the battery cells different from the diagnosis battery cell for each reference time; and
determining whether the diagnosis battery cell is diagnosed normally by comparing the updated maximum value with the first diagnosis deviation of the diagnosis battery cell.

**14.** The operating method of claim 9, wherein the setting of the diagnosis battery cell by diagnosing at least one of the plurality of battery cells based on the first diagnosis deviation of each of the plurality of battery cells comprises:

calculating a second diagnosis deviation of each of the plurality of battery cells based on a reference value obtained by multiplying the second deviation among the first diagnosis deviations of the plurality of respective battery cells by a threshold constant; and
setting the diagnosis battery cell by diagnosing at least one of the plurality of battery cells based on the second diagnosis deviation of each of the plurality of battery cells.

**15.** The operating method of claim 14, wherein the setting of the diagnosis battery cell by diagnosing at least one of the plurality of battery cells based on the second diagnosis deviation of each of the plurality of battery cells comprises:

setting, as the reference value, a maximum value between a value, obtained by multiplying the second deviation by a first threshold constant, and a second threshold constant;
calculating a second diagnosis deviation of each of the plurality of battery cells by excluding a first diagnosis deviation less than or equal to the reference value among the first diagnosis deviations of the plurality of respective battery cells;
performing normalization by dividing the second diagnosis deviation of each of the plurality of battery cells by a maximum value between a value, obtained by multiplying the second deviation by a third threshold constant, and a fourth threshold constant to calculate a third diagnosis deviation of each of the plurality of battery cells;
calculating a skewness of each of the plurality of battery cells by dividing a value, obtained by adding a minimum value among the third diagnosis deviations of the plurality of respective battery cells, to the third diagnosis deviation of each of the plurality of battery cells;
calculating a fourth diagnosis deviation of each of the plurality of battery cells by multiplying the skewness to the third diagnosis deviation of each of the plurality of battery cells; and
setting the diagnosis battery cell by diagnosing at least one of the plurality of battery cells based on whether the fourth diagnosis deviation of each of the plurality of battery cells exceeds a threshold.

300

1000

100

110

120

130

•
•
•

140

BATTERY MANAGEMENT
APPARATUS
200

FIG.1

200

| VOLTAGE MEASUREMENT UNIT 210 | CONTROLLER 220 |

FIG.2

EP 4 660 650 A1

FIG.3

```
                        ┌─────────┐
                        │  START  │
                        └─────────┘
                             │
        ┌────────────────────────────────────────────┐
        │  CALCULATE FIRST DEVIATION THAT IS          │
        │  DEVIATION BETWEEN LONG MOVING AVERAGE       │  ～S101
        │  AND SHORT MOVING AVERAGE OF BATTERY VOLTAGE │
        │  FOR EACH OF PLURALITY OF BATTERY CELLS      │
        └────────────────────────────────────────────┘
                             │
        ┌────────────────────────────────────────────┐
        │  CALCULATE SECOND DEVIATION THAT IS         │
        │  DEVIATION BETWEEN LONG MOVING AVERAGE       │  ～S102
        │  AND SHORT MOVING AVERAGE OF AVERAGE         │
        │  VOLTAGE OF PLURALITY OF BATTERY CELLS       │
        └────────────────────────────────────────────┘
                             │
        ┌────────────────────────────────────────────┐
        │  CALCULATE FIRST DIAGNOSIS DEVIATION        │
        │  THAT IS DIFFERENCE BETWEEN FIRST           │  ～S103
        │  DEVIATION AND SECOND DEVIATION FOR          │
        │  EACH OF PLURALTIY OF BATTERY CELLS          │
        └────────────────────────────────────────────┘
                             │
        ┌────────────────────────────────────────────┐
        │  CALCULATE SECOND DIAGNOSIS DEVIATION       │
        │  FOR EACH OF PLURALITY OF BATTERY CELLS BY   │  ～S104
        │  REMOVING NOISE OF FIRST DIAGNOSIS DEVIATION │
        │  OF EACH OF PLURALITY OF BATTERY CELLS       │
        └────────────────────────────────────────────┘
                             │
        ┌────────────────────────────────────────────┐
        │  CALCULATE THIRD DIAGNOSIS DEVIATION        │
        │  OF EACH OF PLURALITY OF BATTERY CELLS       │  ～S105
        │  BY NORMALIZING SECOND DIAGNOSIS DEVIATION   │
        │  OF EACH OF PLURALITY OF BATTERY CELLS       │
        └────────────────────────────────────────────┘
                             │
        ┌────────────────────────────────────────────┐
        │  CALCULATE FOURTH DIAGNOSIS DEVIATION       │
        │  OF EACH OF PLURALITY OF BATTERY CELLS       │  ～S106
        │  BY MULTIPLYING THIRD DIAGNOSIS DEVIATION OF │
        │  EACH OF PLURALITY OF BATTERY CELLS BY SKEWNESS│
        └────────────────────────────────────────────┘
                             │
                    ╱───────────────╲           S107
                   ╱  FOURTH          ╲
                  ╱   DIAGNOSIS         ╲
                 ⟨ DEVIATION OF EACH OF  ⟩  NO
                  ╲ PLURALITY OF BATTERY ╱ ──────┐
                   ╲ CELLS > THRESHOLD  ╱         │
                    ╲───────────────╱            │
                         │ YES                   │
        ┌────────────────────────────────────────┐  │
        │        DIAGNOSE BATTERY CELL            │  ～S108
        └────────────────────────────────────────┘
                             │
                        ┌─────────┐
                        │   END   │
                        └─────────┘
```

FIG.4

FIG.5A

EP 4 660 650 A1

EP 4 660 650 A1

FIG.5B

FIG.5C

FIG.5D

EP 4 660 650 A1

START

MEASURE VOLTAGE OF ECH OF
PLURALITY OF BATTERY CELLS — S201

CALCULATE FIRST DEVIATION THAT IS
DEVIATION BETWEEN LONG MOVING AVERAGE AND
SHORT MOVING AVERAGE OF BATTERY VOLTAGE
FOR EACH OF PLURALITY OF BATTERY CELLS — S202

CALCULATE SECOND DEVIATION THAT IS
DEVIATION BETWEEN LONG MOVING AVERAGE AND
SHORT MOVING AVERAGE OF AVERAGE VOLTAGE OF
PLURALITY OF BATTERY CELLS — S203

CALCULATE FIRST DIAGNOSIS DEVIATION
THAT IS DIFFERENCE BETWEEN FIRST DEVIATION
AND SECOND DEVIATION FOR EACH
OF PLURALTIY OF BATTERY CELLS — S204

SET DIAGNOSIS BATTERY CELLS BY DIAGNOSING
AT LEAST ONE OF PLURALTIY OF BATTERY CELLS
BASED ON FIRST DIAGNOSIS DEVIATION OF
EACH OF PLURALITY OF BATTERY CELLS — S205

DETERMINE WHETHER DIAGNOSIS BATTERY CELLS
IS DIAGNOSED NORMALLY, BY COMPARING FIRST
DIAGNOSIS DEVIATION OF BATTERY CELLS HAVING
MAXIMUM VALUE AMONG FIRST DIAGNOSIS DEVIATIONS
OF BATTERY CELLS DIFFERENT FROM DIAGNOSIS
BATTERY CELLS WITH FIRST DIAGNOSIS
DEVIATION OF DIAGNOSIS BATTERY CELLS — S206

END

FIG.6

FIG.7

FIG.8A

FIG.8B

InflectionRaw

slot1=[2.0,3.93]
slot2=[2.3,4.0] slot1=[2.5,4.02]
slot2=[1.8,3.96]

2.5
2.3
2.0
1.8

Time(t)

CG1
CG2
CG3
CG4
CG5

DIAGBOSIS BATTERY CELLS
slot_diag=[3.2,4.10]
slot1=[2.5,4.02]
slot2=[3.2,4.10]

InflectionRaw
3.2

Fault=
WAIT FOR
DETERMINATION

Time(t)

DIAGBOSIS BATTERY CELLS
slot_diag=[3.2,4.10]
slot1=[2.5,4.02]
slot2=[3.2,4.10]

InflectionRaw
Threshold
3.2*0.72
=2.304

Fault=
WAIT FOR
DETERMINATION

Time(t)

DIAGBOSIS BATTERY CELLS
slot_diag=[3.2,4.10]
slot1=[2.5,4.02]
slot2=[3.2,4.10]

InflectionRaw
Threshold
3.2*0.72
=2.304

Fault=
MISDIAGNOSIS

Time(t)

FIG.9

30

FIG. 10

START

CALCULATE FIRST DEVIATION THAT IS
DEVIATION BETWEEN LONG MOVING AVERAGE AND
SHORT MOVING AVERAGE OF BATTERY VOLTAGE
FOR EACH OF PLURALITY OF BATTERY CELLS ⟋S301

CALCULATE SECOND DEVIATION THAT IS
DEVIATION BETWEEN LONG MOVING AVERAGE AND
SHORT MOVING AVERAGE OF AVERAGE
VOLTAGE OF PLURALITY OF BATTERIES ⟋S302

CALCULATE FIRST DIAGNOSIS DEVIATION THAT
IS DIFFERENCE BETWEEN FIRST DEVIATION AND
SECOND DEVIATION FOR EACH OF
PLURALTIY OF BATTERY CELLS ⟋S303

CALCULATE SECOND DIAGNOSIS DEVIATION
FOR EACH OF PLURALITY OF BATTERY CELLS BY
REMOVING NOISE OF FIRST DIAGNOSIS DEVIATION
OF EACH OF PLURALITY OF BATTERY CELLS ⟋S304

CALCULATE THIRD DIAGNOSIS DEVIATION OF
EACH OF PLURALITY OF BATTERY CELLS BY
NORMALIZING SECOND DIAGNOSIS DEVIATION
OF EACH OF PLURALITY OF BATTERY CELLS ⟋S305

CALCULATE FOURTH DIAGNOSIS DEVIATION OF
EACH OF PLURALITY OF BATTERY CELLS BY
MULTIPLYING THIRD DIAGNOSIS DEVIATION OF
EACH OF PLURALITY OF BATTERY CELLS BY SKEWNESS ⟋S306

FOURTH
DIAGNOSIS DEVIATION       S307
OF EACH OF PLURALITY
OF BATTERY CELLS >          NO
THRESHOLD

YES

SET DIAGNOSIS BATTERY CELL ⟋S308

DETERMINE WHETHER DIAGNOSIS BATTERY CELL
IS DIAGNOSED NORMALLY, BY COMPARING FIRST
DIAGNOSIS DEVIATION OF BATTERY CELL HAVING
MAXIMUM VALUE AMONG FIRST DIAGNOSIS
DEVIATIONS OF BATTERY CELLS DIFFERENT FROM
DIAGNOSIS BATTERY CELL WITH FIRST DIAGNOSIS
DEVIATION OF DIAGNOSIS BATTERY CELL ⟋S309

END

FIG.11

```
                    ┌──────────────┐
                    │    START     │
                    └──────┬───────┘
                           │
                           ▼
        ┌──────────────────────────────────────┐
        │   CALCULATE FIRST DIAGNOSIS DEVIATION │
        │   OF EACH OF PLURALITY OF BATTERY     │──S401
        │   CELLS FOR EACH REFERENCE TIME       │
        └──────────────────┬───────────────────┘
                           │
                           ▼
        ┌──────────────────────────────────────┐
        │   UPDATE FIRST DIAGNOSIS DEVIATION OF │
        │   BATTERY CELL HAVING MAXIMUM VALUE   │
        │   AMONG FIRST DIAGNOSIS DEVIATIONS OF │──S402
        │   BATTERY CELLS DIFFERENT FROM        │
        │   DIAGNOSIS BATTERY CELL FOR EACH     │
        │   REFERENCE TIME                      │
        └──────────────────┬───────────────────┘
                           │
                           ▼
        ┌──────────────────────────────────────┐
        │   CALCULATE FIRST DIAGNOSIS DEVIATION │
        │   OF DIAGNOSIS BATTERY CELL           │──S403
        │   FOR EACH REFERENCE TIME             │
        └──────────────────┬───────────────────┘
                           │
                           ▼
        ┌──────────────────────────────────────┐
        │   UPDATE MAXIMUM VALUE OF FIRST       │
        │   DIAGNOSIS DEVIATION OF DIAGNOSIS    │──S404
        │   BATTERY CELL FOR EACH REFERENCE TIME│
        └──────────────────┬───────────────────┘
                           │
                           ▼
                    ┌──────────────┐
                    │     END      │
                    └──────────────┘
```

FIG.12

2000

2200

2400

MEMORY

COMMUNICATION
I/F

MCU

INPUT/
OUTPUT I/F

2100

2300

FIG.13

## INTERNATIONAL SEARCH REPORT

| | International application No. |
|---|---|
| | **PCT/KR2024/001613** |

| A. | CLASSIFICATION OF SUBJECT MATTER |
|---|---|

**G01R 31/392**(2019.01)i; **G01R 31/396**(2019.01)i; **G01R 31/385**(2019.01)i; **G01R 19/00**(2006.01)i; **G01R 19/30**(2006.01)i; **G01R 19/165**(2006.01)i; **G01R 31/367**(2019.01)i; **B60L 58/10**(2019.01)i

According to International Patent Classification (IPC) or to both national classification and IPC

| B. | FIELDS SEARCHED |
|---|---|

Minimum documentation searched (classification system followed by classification symbols)

G01R 31/392(2019.01); B60L 3/00(2006.01); B60L 58/20(2019.01); G01R 19/00(2006.01); G01R 31/36(2006.01); G01R 31/382(2019.01); H01M 10/42(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 이동 평균(moving average), 편차(deviation), 최대 (maximum)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2022-0074797 A (LG ENERGY SOLUTION, LTD.) 03 June 2022 (2022-06-03) See paragraphs [0051]-[0166], claims 1-2 and figure 1. | 1-15 |
| Y | KR 10-2022-0146255 A (LG ENERGY SOLUTION, LTD.) 01 November 2022 (2022-11-01) See paragraphs [0102]-[0161]. | 1-15 |
| A | KR 10-2021-0022417 A (LG CHEM, LTD.) 03 March 2021 (2021-03-03) See paragraphs [0033]-[0043]. | 1-15 |
| A | JP 2002-334722 A (MATSUSHITA ELECTRIC IND. CO., LTD. et al.) 22 November 2002 (2002-11-22) See paragraphs [0018]-[0039]. | 1-15 |
| A | CN 114518539 A (BEIJING JIAOTONG UNIVERSITY) 20 May 2022 (2022-05-20) See paragraphs [0029]-[0039]. | 1-15 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **01 May 2024** | **02 May 2024** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/001613**

| Patent document cited in search report | | | Publication date (day/month/year) | Patent family member(s) | | | Publication date (day/month/year) |
|---|---|---|---|---|---|---|---|
| KR | 10-2022-0074797 | A | 03 June 2022 | CN | 115461634 | A | 09 December 2022 |
| | | | | EP | 4152021 | A1 | 22 March 2023 |
| | | | | EP | 4152021 | A4 | 03 January 2024 |
| | | | | JP | 2023-519949 | A | 15 May 2023 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2022-0146255 | A | 01 November 2022 | | None | | |
| KR | 10-2021-0022417 | A | 03 March 2021 | KR | 10-2649989 | B1 | 20 March 2024 |
| JP | 2002-334722 | A | 22 November 2002 | | None | | |
| CN | 114518539 | A | 20 May 2022 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230059022